# EUROPEAN PATENT APPLICATION

(11) **EP 4 831 737 A1**
(43) Date of publication of application: **28.10.2026**
(21) Application number: 26173902.3
(22) Date of filing: 22.04.2026
(51) Int. Cl.: G03F 7/00

(54) **APPARATUS FOR SEMICONDUCTOR TECHNOLOGY**

(30) Priority: 23.04.2025 DE 102025115585
(71) Applicant: Carl Zeiss SMT GmbH, 73447 Oberkochen (DE)
(72) Inventor: Goecke, Rusbeh, 73447 Oberkochen (DE)
(74) Representative: GLAWE DELFS MOLL

(57) **Abstract**

The invention relates to an apparatus (1) for semiconductor technology comprising a closed system space (10), in which a defined system atmosphere prevails and in which system components (20) are arranged.

The system space (10) has at least one exchange opening (31) which can be closed in a gas-tight manner for the exchange of at least one system component (20) arranged in the system space (10), wherein the exchange opening (31) is surrounded by a purge device (40) designed to form a flow curtain (42) from purge gas flowing away from the system space (10) of the apparatus (1), said purge gas being free of relevant contaminants, for the purpose of eliminating contaminations on a system component (20) to be introduced through the exchange opening (31).

## Description

The invention relates to an apparatus for semiconductor technology, in particular such apparatuses comprising a closed system space, in which a defined system atmosphere prevails and in which system components are arranged. The present patent application claims the priority of the German patent application DE 10 2025 115 585.2 filed on 23 April 2025, with reference being made thereto and the content thereof being incorporated in full here ("incorporation by reference").

In the prior art, those apparatuses which are used to produce or test microstructured parts or the components required therefor are referred to as apparatuses for semiconductor technology. One example of such an apparatus is a photolithographic projection exposure apparatus.

Photolithography is used for producing microstructured parts, such as e.g. integrated circuits. The projection exposure apparatus used in the process comprises an illumination system and a projection system. The image of a mask (also referred to as a reticle) illuminated by the illumination system is projected so as to reduce the size of the former onto a substrate, for example a silicon wafer, which is coated with a light-sensitive layer and arranged in the image plane of the projection system, using the projection system in order to transfer the mask structure to the light-sensitive coating of the substrate.

Irrespective of the wavelength used for the exposure of the substrate, it is regularly necessary for the region of the beam path from the radiation source through the illumination system, via the reticle and through the projection system as far as the substrate and also the optical elements participating in the beam path, such as mirrors or lens elements, to be kept as free of contaminations as possible in order to influence the beam path as little as possible. For this purpose, the components relevant to the beam path are generally arranged in a closed system space of the apparatus for semiconductor technology in such a way that said beam path from the radiation source as far as the substrate also runs completely within the system space. A defined system atmosphere prevails in the system space, said system atmosphere being monitored and set by a control unit. However, the system atmosphere is chosen in particular such that the exposure radiation is not absorbed by it and also the least possible amount of undesired constituents is deposited at least on the optical surfaces of the optical elements.

In the case of EUV exposure radiation - i.e. exposure radiation having a wavelength of 5 nm to 30 nm, in particular of 13.5 nm - the system atmosphere may be, for example, a hydrogen atmosphere at extremely low pressure. In the case of DUV exposure radiation having a wavelength of e.g. 193 nm or 248 nm, the system atmosphere may also be air or nitrogen at ambient pressure, but it must regularly be ensured that this atmosphere is free of contaminations. Very low air humidity is required as well.

If - e.g. on account of optical degradation - an element arranged in the system space needs to be exchanged, in the prior art it is regularly necessary to open the system space. Both as a result of the opening of the system space and as a result of the introduction of an exchange element, the atmosphere in the system space changes and contaminations may be introduced. In the prior art, therefore, after the exchange of an element, it is often necessary to carry out a complex cleaning process, including a complete exchange of the system atmosphere.

It is an object of the present invention to provide an apparatus for semiconductor technology in which a simplified exchange of an element arranged in the system space is possible.

This object is achieved by an apparatus according to Claim 1. The dependent claims relate to advantageous developments.

Accordingly, the invention relates to an apparatus for semiconductor technology comprising a closed system space, in which a defined system atmosphere prevails and in which system components are arranged, wherein the system space has at least one exchange opening which can be closed in a gas-tight manner for the exchange of at least one system component arranged in the system space, wherein the exchange opening is surrounded by a purge device designed to form a flow curtain from purge gas flowing away from the system space of the apparatus for the purpose of eliminating contaminations on a system component to be introduced through the exchange opening.

"Contaminations" in connection with the invention are any foreign substances which, if they enter the system space, may adversely affect the operation of the apparatus for semiconductor technology. Contaminations may be e.g. dust particles, but also molecules that absorb the exposure radiation or substances that adversely affect optical surfaces in the system space.

The invention has recognized that, even if strict clean room guidelines are observed in the environment of an apparatus for semiconductor technology, when a system component arranged in the system space with a defined system atmosphere is exchanged, the risk of contaminations being introduced during the actual exchange process, in particular contaminations situated directly on the newly inserted system component, can be significantly reduced if the system component in question is cleaned with the aid of a purge gas directly before being introduced into the system space. For this purpose, it is provided according to the invention that that exchange opening through which the new system component is intended to be introduced and which is closed in a gas-tight manner during normal operation of the apparatus is surrounded by a purge device designed to form a flow curtain serving to eliminate possible contaminations on a system component to be introduced through the exchange opening. For this purpose, the flow curtain is formed from a purge gas which itself is free of any contaminations relevant to the system atmosphere in regard to the system space. In other words, even if purge gas enters the system space, no relevant contaminations are introduced as a result. Moreover, the purge gas in principle flows away from the system space of the apparatus, so that any foreign substances that the purge gas has possibly detached from the system component to be introduced are carried away from the system space and thus cannot enter the latter.

It is preferred if the purge device is designed to generate a flow which is as laminar as possible around the system component to be introduced through the exchange opening. The laminar flow around the system component affords the advantage that foreign substances situated on the surface of the system component to be introduced can be transported away, but at the same time there is only a slight risk that foreign substances taken up from the system component will be deposited on the latter again or the foreign substances will enter the system space.

It may nevertheless be preferred for the purge device to be designed to introduce pressure surges of the purge gas for generating turbulence. As a result of the intermittent introduction of turbulence into the flow around the system component to be introduced, contaminations adhering thereto may possibly be detached better than from a laminar flow around. In principle, a turbulent flow around is preferably always followed by a laminar flow around, in order to ensure the removal of any contaminations possibly loosely deposited on the system component to be introduced, during the turbulent flow around.

It is also possible for the purge device to be designed to cause increases in the temperature of the purge gas at least intermittently. As a result of the at least intermittent increase in temperature, diffusion processes away from the surface of the system component to be introduced into the laminar flow can be accelerated in order to then transport the contaminations away with the flow.

It is preferred if the purge device comprises guide surfaces for guiding the flow curtain in sections around a system component to be introduced. Corresponding guide surfaces make it possible to ensure that the flow curtain sweeps over the system component to be introduced over as long a section as possible. Moreover, with a suitable design of the guide surfaces, in principle a laminar flow can be ensured over a relatively long section. Last but not least, the guide surfaces make it possible to ensure that no contaminations can be introduced into the flow curtain laterally from outside.

If guide surfaces are provided, the purge device is preferably designed to clean the guide surfaces by removing contaminations with the aid of purge gas before the exchange opening is opened. Especially if the cleaning of the guide surfaces is carried out before the exchange opening is opened and, if appropriate, also before a system component to be introduced is brought into the region of the guide surfaces, any contaminations possibly present on the guide surfaces can be removed without said contaminations being able to reach the system space and/or the system component to be introduced. In this case, the space between the guide surfaces can also be purged, i.e. the possibly contaminated gas situated between the guide surfaces in the initial state is replaced by purge gas emerging from the purge device.

If the apparatus for semiconductor technology, as is regularly provided, has a control unit for monitoring and setting the system atmosphere, said control unit is preferably designed to raise the pressure of the system atmosphere in the system space to a pressure higher than the ambient pressure before and/or during the opening of an exchange opening. If the pressure in the system space is correspondingly increased, a flow leading from the system space into the environment arises after the opening of an exchange opening. Such a flow at least reduces the risk of contaminations entering the system space.

It is preferred for the flow velocity of the purge gas to be controllable, wherein preferably a control unit is provided, by means of which the flow velocity resulting from the purge gas and/or system atmosphere emerging from the exchange opening yields mass transfer Péclet numbers of greater than 1, in each case relative to relevant contaminants and the length of the flow curtain. If the mass transfer Peclét number for a specific contamination is greater than 1, it is ensured that the mass transfer on account of the flow of the purge gas away from the system space is greater than any opposite mass transfer on account of diffusion. As a result, the risk of contamination of the system space on account of diffusion can be significantly reduced.

The purge gas introduced by the purge device preferably has a purity class comparable to class 0 according to ISO 8573-1:2010 and hence purer than class 1 according to ISO 8573-1:2010. Even if the purge gas need not necessarily be air, the aforementioned purity class nevertheless ensures in principle that the purge gas itself is practically free of any possible contaminations.

It is preferred if at least one exchange opening is arranged and formed in such a way that the exchange path is one-dimensional for at least one system component to be exchanged through these exchange openings. An exchange path is deemed to be one-dimensional if a system component has to be guided exclusively along a rectilinear path for the exchange. If the exchange path is one-dimensional, the system component to be introduced can also be guided past the purge device along this path or the extension thereof. The purge device can then be optimized for this exchange path.

It is preferred if a system component to be exchanged through the exchange opening is optimized with regard to the flow around with purge gas of the flow curtain generated by the purge device. Depending on the design of the system component, in the initial state regions may arise which are not included on the part of the purge gas introduced by the purge device. Providing suitable flow channels and/or other design adaptations of the system component to be introduced enables corresponding regions to be reduced or even completely avoided.

The invention will now be described by way of example with reference to the accompanying drawings, in which:
- Figure 1:: shows a schematic partial illustration of a first exemplary embodiment of an apparatus according to the invention for semiconductor technology;
- Figure 2:: shows a schematic illustration of the apparatus according to Figure 1 before the exchange opening is opened;
- Figure 3:: shows a schematic illustration of the apparatus according to Figure 1 during the introduction of a system component through the exchange opening; and
- Figure 4:: shows an embodiment variant with respect to Figure 3.

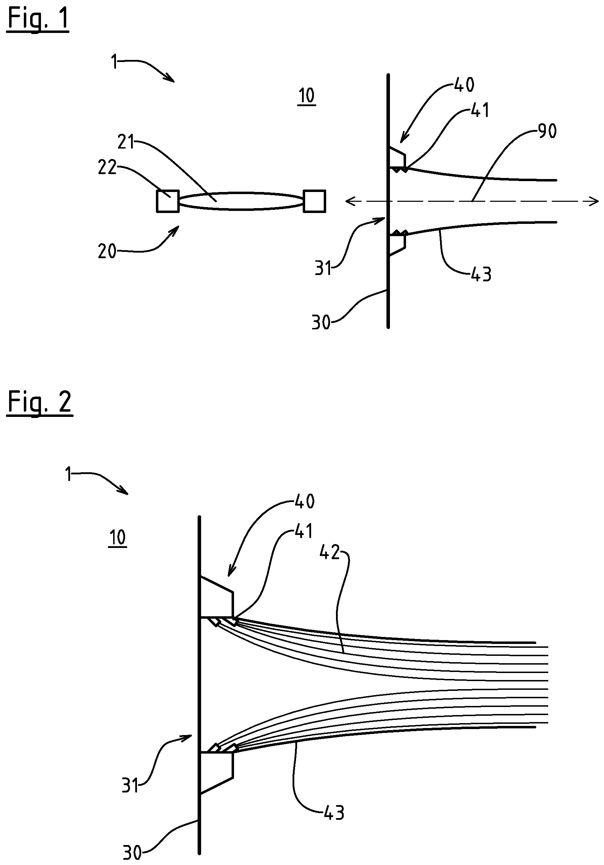

Figure 1 schematically illustrates one exemplary embodiment of an apparatus 1 according to the invention for semiconductor technology, the illustration being limited to a part of the boundary wall 30 of a closed system space 10 of the apparatus 1. A defined system atmosphere prevails in the system space 10 of the apparatus 1 (to the left of the boundary wall 30), said system atmosphere being monitored and controlled by a control unit (not illustrated).

Various system components 20 of the apparatus 10 are arranged in the system space 10. In the illustrated part of the exemplary embodiment, the system component 20 is an optical element 21 for radiation transformation, e.g. a lens element or a mirror, which optical element is surrounded by a circumferential mount 22.

For the exchange of the system component 20, which may become necessary for example on account of optical degradation, an exchange opening 31 which can be closed in a gas-tight manner is provided in the boundary wall 30. The exchange opening 31 is in principle arranged in such a way that the system component 20 can be exchanged along a one-dimensional exchange path, which is indicated by the dashed double-headed arrow 90. In other words, the system component 20 to be exchanged which is situated in the system space 10 can be removed from the apparatus 1 by a rectilinear movement and a new system component 20 can be introduced into the system space 10 by a likewise rectilinear movement, albeit in the opposite direction.

In order to prevent contaminations from also entering the system space 10 together with the introduction of a new system component 20 into said system space, a purge device 40 is provided.

The purge device 40 surrounds the exchange opening 31 completely - i.e. thus also on the sides of the exchange opening 31 - and comprises gas outlets 41 pointing inwards but from the exchange opening 31 or the system space 10. A purge gas can be introduced via these gas outlets 41, and then forms a flow curtain 42 flowing away from the system space 10 of the apparatus 1 (cf. Figures 2-4). For shaping the flow curtain 42, guide surfaces 43 are provided, by means of which the flow curtain 42 is shaped at least for a length predefined by way of the guide surfaces 43, where a laminar flow is generally established.

Figure 2 illustrates the flow curtain 42 formed from purge gas while the exchange opening 31 is still closed. In this state, the flow is completely laminar at least in the region of the guide surfaces 43, as a result of which contaminations, for example in the form of dust particles or molecules potentially contaminating the system space 10, which are situated on the inner side of the guide surfaces 43 are purged away from the guide surfaces 43 and/or from the space enclosed by the guide surfaces 43.

Once the guide surfaces 43 have been sufficiently cleaned of contaminations by the measure illustrated in Figure 2, the exchange opening 31 can subsequently be opened. In this case, it is expedient, before the exchange opening 31 is actually opened, to increase and maintain the pressure in the interior of the system space 10 in such a way that there is an overpressure there relative to the environment of the apparatus 1. The same can correspondingly be accomplished by means of the control unit for controlling the system atmosphere. As a result, it is ensured that after the exchange opening 31 has been opened, a continuous gas flow from the system space 10 through the exchange opening 31 into the environment is established, by means of which at least an entry of dust particles or the like through the exchange opening 31 into the system space 10 can already be effectively avoided.

Furthermore, the flow velocity of the purge gas introduced through the gas outlets 41 is controlled by a control unit (not illustrated) in such a way that for the flow of the purge gas and the gas emerging from the system space 10, a flow velocity results for which a mass transfer Peclét number of greater than 1 is obtained in each case over the length predefined by the guide surfaces 43 and over contaminants previously identified as relevant. This ensures that any diffusion transport of relevant contaminants from the environment through the exchange opening 31 into the system space 10 is effectively reduced.

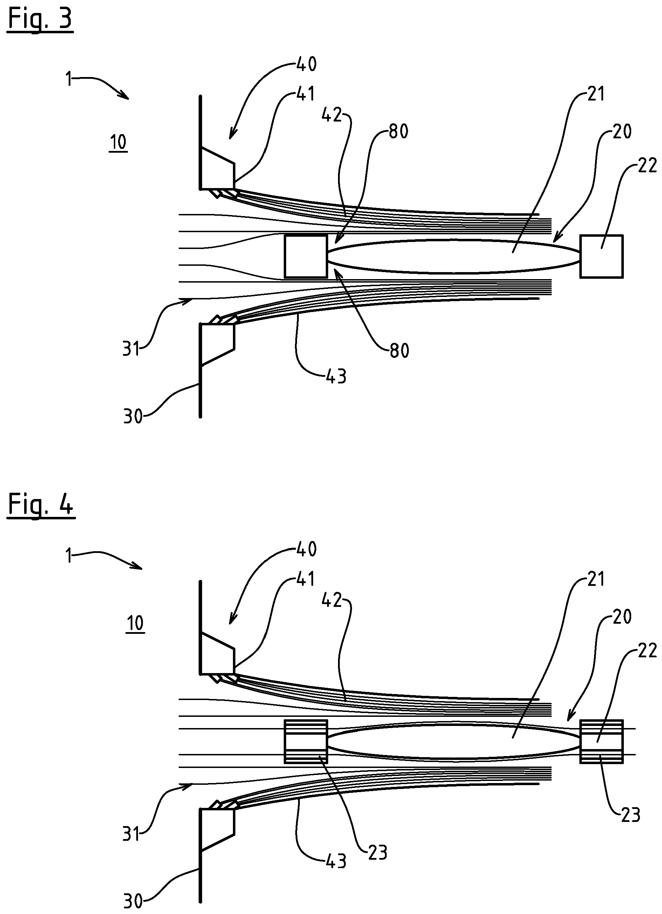

After the exchange opening 31 has been opened, the system components 20 to be exchanged can be removed from the system space 10 through the flow curtain 42, wherein a flow around the removed system component 20 is established, as is illustrated in Figure 3 for the system component 20 to be subsequently inserted into the system space 10.

Figure 3 illustrates how a new system component 20 is introduced through the exchange opening 31 along the exchange path 90 (cf. Figure 1). In this case, the new system component 20 is guided through the flow curtain 42 formed between the guide surfaces 43, which flow curtain is composed of purge gas and is supplemented by the gas flow 44 from the system space 10 into the environment. On account of the guide surfaces 43, a substantially laminar flow around the system component 20 results, by means of which any contaminations possibly situated on the system component 20 can and ought to be removed - namely purged away.

Both for cleaning the guide surfaces 43 and when introducing a system component 20, it can be helpful to intermittently generate turbulence in the flow curtain 42. For this purpose, provision can be made for the purge device 40 to be designed for introducing pressure surges into the purge gas. In any case, however, provision should be made for a period of time with a turbulent flow of the purge gas to be followed by a period of time with a laminar flow in order to remove any contaminations deposited on account of the turbulence from the guide surfaces 43 and/or the system component 20 to be introduced.

The exemplary embodiment according to Figure 3 reveals regions 80 on the system component 20 into which a laminar flow, as illustrated, does not penetrate. As a result, undesired contaminations may remain in precisely these regions 80 and may be introduced into the system space 10 together with the system component 20.

In order to minimize this risk, in the embodiment variant according to Figure 4, the system component 20 to be introduced is itself optimized with regard to the flow of the purge gas around it. In this regard, flow channels 23 are introduced in the mount 22 of the optical element 21, through which flow channels the purge gas or gas emerging from the system space 10 on account of an overpressure relative to the environment can flow in order that gas can flow even over otherwise hard-to-reach locations and contaminations can thus be eliminated therefrom.

In all exemplary embodiments, the purge gas has a purity class comparable to class 0 defined for air in ISO 8573-1:2010, i.e. purge gas itself has practically no contaminations and practically no moisture either.

## Claims

1. Apparatus (1) for semiconductor technology comprising a closed system space (10), in which a defined system atmosphere prevails and in which system components (20) are arranged, **characterized in that** the system space (10) has at least one exchange opening (31) which can be closed in a gas-tight manner for the exchange of at least one system component (20) arranged in the system space (10), wherein the exchange opening (31) is surrounded by a purge device (40) designed to form a flow curtain (42) from purge gas flowing away from the system space (10) of the apparatus (1) for the purpose of eliminating contaminations on a system component (20) to be introduced through the exchange opening (31).

2. Apparatus according to Claim 1,
**characterized in that**
the purge device (40) is designed to generate a flow which is as laminar as possible around the system component (20) to be introduced through the exchange opening (31).

3. Apparatus according to either of the preceding claims,
**characterized in that**
the purge device (40) is designed to introduce pressure surges for generating turbulence.

4. Apparatus according to any of the preceding claims,
**characterized in that**
the purge device (40) is designed to cause increases in the temperature of the purge gas at least intermittently.

5. Apparatus according to any of the preceding claims,
**characterized in that**
the purge device (40) comprises guide surfaces (43) for guiding the flow curtain (42) in sections around a system component (20) to be introduced.

6. Apparatus according to Claim 3,
**characterized in that**
the purge device (40) is designed to clean the guide surfaces (43) by removing contaminations with the aid of purge gas before the exchange opening (31) is opened.

7. Apparatus according to any of the preceding claims,
**characterized in that**
the apparatus (1) comprises a control unit for monitoring and setting the system atmosphere in the system space (10), which control unit is designed to raise the pressure of the system atmosphere in the system space (10) to a pressure higher than the ambient pressure before and/or during the opening of an exchange opening (31).

8. Apparatus according to any of the preceding claims,
**characterized in that**
the flow velocity of the purge gas is controllable, wherein preferably a control unit is provided, by means of which the flow velocity resulting from the purge gas and/or system atmosphere emerging from the exchange opening (31) yields mass transfer Péclet numbers of greater than 1, in each case relative to relevant contaminants and the length of the flow curtain (42).

9. Apparatus according to any of the preceding claims,
**characterized in that**
the purge gas introduced by the purge device (40) has a purity class comparable to class 0 according to ISO 8573-1:2010 and hence purer than class 1 according to ISO 8573-1:2010.

10. Apparatus according to any of the preceding claims, **characterized in that** at least one exchange opening (31) is arranged and formed in such a way that the exchange path (90) is one-dimensional for at least one system component (20) to be exchanged through these exchange openings (31).

11. Apparatus according to any of the preceding claims, **characterized in that** a system component (20) to be exchanged through the exchange opening (31) is optimized with regard to the flow around with purge gas of the flow curtain (42) generated by the purge device (40).
